# EUROPÄISCHE PATENTSCHRIFT

(11) **EP 0 724 163 B1**
(45) Veröffentlichungstag und Bekanntmachung des Hinweises auf die Patenterteilung: **21.10.1998**
(21) Anmeldenummer: 96200123.6
(22) Anmeldetag: 18.01.1996
(51) Int. Cl.: G01R 33/3415, G01R 33/565, G01R 33/54

(54) **MR-Verfahren mit induktiv gekoppelten Empfangs-Spulenanordnungen**
MR method using inductively coupled receiver coil arrangements
Procédé de RMN utilisant des agencements de bobines réceptrices à couplage inductif

(30) Priorität: 26.01.1995 DE 19502374
(43) Veröffentlichungstag der Anmeldung: 31.07.1996
(73) Patentinhaber: Philips Patentverwaltung GmbH, 22335 Hamburg (DE); Koninklijke Philips Electronics N.V., 5621 BA Eindhoven (NL)
(72) Erfinder: Börnert, Peter, Dr., D-22335 Hamburg (DE)
(74) Vertreter: Hartmann, Heinrich, Dipl.-Ing.

(56) Entgegenhaltungen:
- EP-A- 0 271 123

## Beschreibung

Die Erfindung betrifft ein MR-Verfahren, bei dem mehrere miteinander induktiv gekoppelte Empfangs-Spulenanordnungen vorgesehen sind.. Außerdem betrifft die Erfindung ein MR-Gerät zur Durchführung dieses Verfahrens.

Bei MR-Untersuchungen (MR = Magnetic-Resonance) besteht bei bestimmten Untersuchungen das Bedürfnis, MR-Signale aus demselben räumlichen Bereich eines Untersuchungsobjekts mit verschiedenen, miteinander induktiv gekoppelten Spulen aufzunehmen. So ist es aus der EP-OS 271 123 bekannt, einerseits mit einer Ganzkörperspule und andererseits mit einer Oberflächenspule ein MR-Bild zu erstellen. Mit dem Bild der Ganzkörperspule, die eine geringe, aber örtlich homogene Empfindlichkeit hat, soll das Bild der Oberflächenspule korrigiert werden, die eine große Empfindlichkeit hat, welche jedoch stark ortsabhängig ist. Wenn die beiden Spulenanordnungen induktiv miteinander gekoppelt sind und wenn die MR-Signale von beiden Spulen gleichzeitig empfangen werden, stellen sich unaktzeptable Ergebnisse ein, z.B. Bildartefakte und eine drastische Verschlechterung des Signal/Rausch-Verhältnisses. Bei einer Variante des bekannten Verfahrens werden die MR-Signale daher zeitlich nacheinander aufgenommen. Wenn während des Signalempfangs die Spulen auf geeignete Weise voneinander entkoppelt würden, würden sich die geschilderten negativen Effekte bei gleichzeitigem Signalempfang aber vermeiden lassen.

Die gleichen Probleme ergeben sich, wenn statt einer Oberflächenspule eine aus mehreren Oberflächenspulen bestehende Empfangs-Spulenanordnung verwendet wird, wie aus der EP-OS 412 824 (Fig. 16) bekannt, wobei die Verhältnisse noch komplizierter werden, wenn die einzelnen Oberflächenspulen auch noch untereinander gekoppelt sind. Auch bei interventionellen MR-Untersuchungen könnten sich die gleichen Probleme ergeben, wenn ein Katheter oder ein chirurgisches Gerät zwecks Lokalisierung mit einer kleinen Signal-Empfangsspule versehen ist und wenn parallel dazu eine global oder lokal empfangende zweite Spule benutzt wird.

Wie bereits erwähnt, lassen sich diese Probleme vermeiden, wenn alle Spulen, die miteinander induktiv gekoppelt sind, die Signale nicht gleichzeitig empfangen, sondern nacheinander, und wenn die jeweils nicht empfangenden Spulen so betrieben werden, daß sie in dieser Phase elektrisch unwirksam sind, z.B. durch Verstimmung oder durch Dämpfung. Durch dieses Vorgehen verlängern sich aber die zum Aufnehmen der MR-Signale erforderlichen Meßzeit, und es kann vorkommen, daß sich das Objekt in unterschiedlichen Zuständen befindet (Bewegung etc.), so daß die aus den getrennten Messungen resultierenden MR-Bilder nur schwer aufeinander zu beziehen sind.

Aufgabe der vorliegenden Erfindung ist es, ein Verfahren zu schaffen, das bei miteinander gekoppelten Empfangs-Spulenanordnungen einwandfreie Ergebnisse liefert, ohne die Meßzeit wesentlich zu verlängern. Diese Aufgabe wird erfindungsgemäß durch folgende Verfahrensschritte gelöst,
a) Anregen der Kernmagnetisierung in einem Untersuchungsbereich, der einem homogenen stationären Magnetfeld ausgesetzt ist, mit wenigstens einem Hochfrequenzimpuls
b) mehrfache Rephasierung der angeregten Kernmagnetisierung zur Erzeugung mehrerer MR-Echosignale, deren Zahl mindestens gleich der Zahl m der Empfangs-Spulenanordnungen ist,
c) Umschalten der Empfangs-Spulenanordnungen derart, daß jede Empfangs-Spulenanordnung im Anschluß an diese Anregung mindestens ein MR-Echosignal empfängt, während alle übrigen Spulenanordnungen jeweils inaktiv sind.

Bei der Erfindung wird die einmal angeregte Kernmagnetisierung also mehrfach ausgelesen, indem sie mehrfach rephasiert wird, so daß bei jeder Rephasierung ein MR-Echosignal entsteht, wobei jede Empfangs-Spulenanordnung wenigstens ein MR-Echosignal empfängt, während gleichzeitig die anderen Empfangs-Spulenanordnungen inaktiviert und somit entkoppelt sind. Da die MR-Echosignale auf diese Weise nahezu gleichzeitig aufgenommen werden, werden die daraus abgeleiteten MR-Bilder durch Bewegungen und/oder den eventuellen Aufbau eines Gleichgewichtszustandes der verfügbaren Magnetisierung bei schnell repetierten Sequenzen nicht in unterschiedlicher Weise beeinflußt. Die Meßzeit wird nur unwesentlich verlängert.

Die Rephasierung der Kernmagnetisierung kann durch jeweils einen 180°-Hochfrequenzimpuls erfolgen, woraus sich eine Sequenz ergibt, die in ähnlicher Form unter dem Namen RARE bekannt ist. Stattdessen kann die Rephasierung aber auch dadurch erfolgen, daß die Polarität des Lesegradienten in dessen Anwesenheit die MR-Echosignale erfaßt werden, ständig umgeschaltet wird, so daß sich eine Sequenz vom EPI-Typ ergibt. Auch Mischformen sind möglich, beispielsweise indem jeweils nach mehreren Polaritätswechseln des Lesegradienten ein 180°-Refokussierungsimpuls erzeugt wird, was auf eine dem GRASE-Typ ähnliche Sequenz hinausläuft. Der Unterschied der Erfindung zu diesen an sich bekannten Sequenzen besteht u.a. darin, daß die MR-Echosignale nicht von einer Empfangs-Spulenanordnung aufgenommen werden, sondern im Wechsel von jeweils einer der unterschiedlichen Empfangs-Spulenanordnungen.

Eine Empfangs-Spulenanordnung kann eine Empfangsspule oder mehrere, nicht miteinander gekoppelte Empfangsspulen umfassen, deren Signale getrennt voneinander verarbeitet werden. Die Inaktivierung der das momentan auftretende MR-Echosignal nicht empfangenden Empfangs-Spulenanordnungen kann dadurch erfolgen, daß diese so verstimmt oder bedämpft werden, daß sie den Empfang des MR-Echosignals durch die jeweils aktive Empfangsspulen-Anordnung nicht beeinflussen können.

Es sei an dieser Stelle erwähnt, daß diese Inaktivierung von nicht zum Empfang des momentan auftretenden MR-Signals bestimmten Spulen an sich aus der DE-OS 40 30 878 (= US-PS 5,221,901) sowie aus der US-PS 5,216,367 bekannt ist. Diese Spulen dienen jedoch dazu, die zu unterschiedlichen Zeiten und an unterschiedlichen Orten innerhalb des Untersuchungsbereichs angeregten Kernmagnetisierungen auszulesen. So ist beispielsweise in den Figuren 2 und 3 der US- PS 5,216,367 ein Multislice-Verfahren beschrieben, bei dem alternierend Schichten auf der linken und auf der rechten Seite des Schädels angeregt werden, wobei bei jeder Anregung nur ein MR-Signal von einer der beiden links bzw. rechts vom Schädel befindlichen Oberflächenspulen ausgelesen werden.

Die Erfindung ist auch bei MR-Verfahren anwendbar, bei denen die verschiedenen Empfangs-Spulenanordnungen nicht gleich viele MR-Signale empfangen müssen. Für die MR-Anwendungen jedoch, bei denen die Empfangs-Spulenanordnungen die gleiche Zahl von MR-Signalen verarbeiten müssen, sieht eine Weiterbildung der Erfindung vor, daß m·n MR-Echosignale im Anschluß an eine Anregung der Kernmagnetisierung erzeugt werden, wobei m die Zahl der Empfangs-Spulenanordnungen ist und n eine ganze Zahl größer als Null, und daß die Empfangs-Spulenanordnungen zyklisch umgeschaltet werden, so daß jede Empfangs-Spulenanordnung insgesamt n MR-Echosignale empfängt. Dabei gibt es verschiedene Möglichkeiten für die durch das zyklische Umschalten der Empfangs-Spulenanordnungen definierten Empfangs-Zyklen:

Eine erste Möglichkeit besteht in weiterer Ausgestaltung der Erfindung darin, daß die Empfangs-Spulenanordnungen im Anschluß an eine einzige Anregung in n Empfangs-Zyklen aktiviert werden, wobei in jedem Empfangs-Zyklus alle Empfangs-Spulenanordnungen je ein in gleicher Weise von den Gradientenfeldern beeinflußtes MR-Echosignal empfangen wie die anderen Empfangs-Spulenanordnungen, und daß von Empfangs-Zyklus zu Empfangs-Zyklus die frequenz- oder phasenbestimmenden Gradienten variiert werden. Pro Empfangszyklus empfängt jede Empfangs-Spulenanordnung also nur ein MR-Echosignal. Sie ist dabei von allen anderen entkoppelt, da diese inaktiviert sind.

Eine andere Möglichkeit besteht nach einer anderen Ausgestaltung der Erfindung darin, daß die Empfangs-Spulenanordnungen im Anschluß an eine Anregung in einem einzigen Empfangs-Zyklus aktiviert werden, in dem jede Empfangs-Spulenanordnung nacheinander n MR-Signale erfaßt, wobei aufeinanderfolgenden MR-Echosignale in unterschiedlicher Weise von einem Phasenkodiergradienten beeinflußt werden.

Während bei der einen Möglichkeit n Empfangs-Zyklen durchlaufen werden, wobei die Empfangs-Spulenanordnungen in jedem Empfangs-Zyklus nur jeweils ein MR-Echosignal empfangen, ist bei der anderen Möglichkeit nur ein einziger Empfangs-Zyklus vorgesehen, wobei jede Empfangs-Spulenanordnung nacheinander alle n dafür bestimmten MR-Echosignale erfaßt.

Eine vorteilhafte Weiterbildung der ersten Methode, wobei z.B. von nur zwei Empfangs-Spulenanordnungen ausgegangen wird, besteht darin, daß die Rephasierung der Kernmagnetisierung mittels eines Lesegradienten mit alternierender Polarität erfolgt, wobei die Empfangs-Zyklen so gestaltet sind, daß jede Empfangs-Spulenanordnung nur MR-Echosignale empfängt, die bei derselben Polarität des Lesegradienten auftreten, und daß zwischen aufeinanderfolgenden Empfangs-Zyklen ein Phasenkodiergradient geändert wird. Da jede Empfangs-Spulenanordnung nur MR-Echosignale empfängt, die bei ein und derselben Polarität des Lesegradienten auftreten, werden die sogenannten N/2 Geisterbilder vermieden, die sonst bei einer solchen EPI-Sequenz beobachtet werden können.

In noch weiterer Ausgestaltung ist dabei vorgesehen, daß die beiden Spulenanordnungen alternierend eingeschaltet werden und daß aus den MR-Echosignalen beider Spulenanordnungen Kalibrationsdaten zur Korrektur der örtlich inhomogener Empfindlichkeit
der Oberflächen-Spulenanordnung abgeleitet werden. Aus den so gewonnenen Kalibrationsdaten können die MR-Bilder, die mit der Oberflächen-Spulenanordnung in weiteren MR-Messungen (mit u.U. ganz anderen Sequenzen) gewonnen wurden, korrigiert werden. Die Oberflächen-Spulenanordnung kann dabei aus mehreren Oberflächenspulen bestehen, wobei die so gebildete sogenannte "Synergiespule" eine hohe (örtlich inhomogene) Empfindlichkeit bzw. ein sehr gutes Signal/Rauschverhältnis aufweist .

Ein MR-Gerät zur Durchführung des Verfahrens nach Anspruch 1 ist erfindungsgemäß versehen mit
einem Magneten zur Erzeugung eines homogenen stationären Magnetfeldes,
einer an einen Sender anschließbaren Spulenanordnung zur Erzeugung von Hochfrequenzimpulsen zwecks Anregung der Kernmagnetisierung,
Gradientenspulenanordnungen zur Erzeugung magnetischer Gradientenfelder,
mindestens zwei induktiv miteinander gekoppelten Empfangs-Spulenanordnungen,
Umschalt-Mitteln zum Umschalten der Empfangs-Spulenanordnungen derart, daß jeweils nur eine Empfangs-Spulenanordnung empfangen kann, und
einer Steuereinheit zur Steuerung der Komponenten des MR-Gerätes derart, daß sich folgender Ablauf ergibt:
   a) Anregen der Kernmagnetisierung in einem Untersuchungsbereich, der einem homogenen stationären Magnetfeld ausgesetzt ist, mit wenigstens einem Hochfrequenzimpuls
   b) mehrfache Rephasierung der angeregten Kernmagnetisierung zur Erzeugung mehrerer MR-Echosignale, deren Zahl mindestens gleich der Zahl m der Empfangs-Spulenanordnungen ist,
   c) Umschalten der Empfangs-Spulenanordnungen derart, daß jede Empfangs-Spulenanordnung im Anschluß an diese Anregung mindestens ein MR-Echosignal empfängt, während alle übrigen Empfangsspulenanordnungen jeweils inaktiv sind.

Die Erfindung wird nachstehend anhand der Zeichnungen näher erläutert. Es zeigen
- Fig. 1: ein Blockschaltbild eines MR-Gerätes, das die Erfindung beinhalten kann,
- Fig. 2: eine Darstellung einer Körper-Spulenanordnung und einer Oberflächen-Spulenanordnung,
- Fig. 3: den zeitlichen Verlauf verschiedener Signale bei einer ersten Variante des erfindungsgemäßen Verfahrens,
- Fig. 4: den zeitlichen Verlauf dieser Signale bei einer zweiten Variante

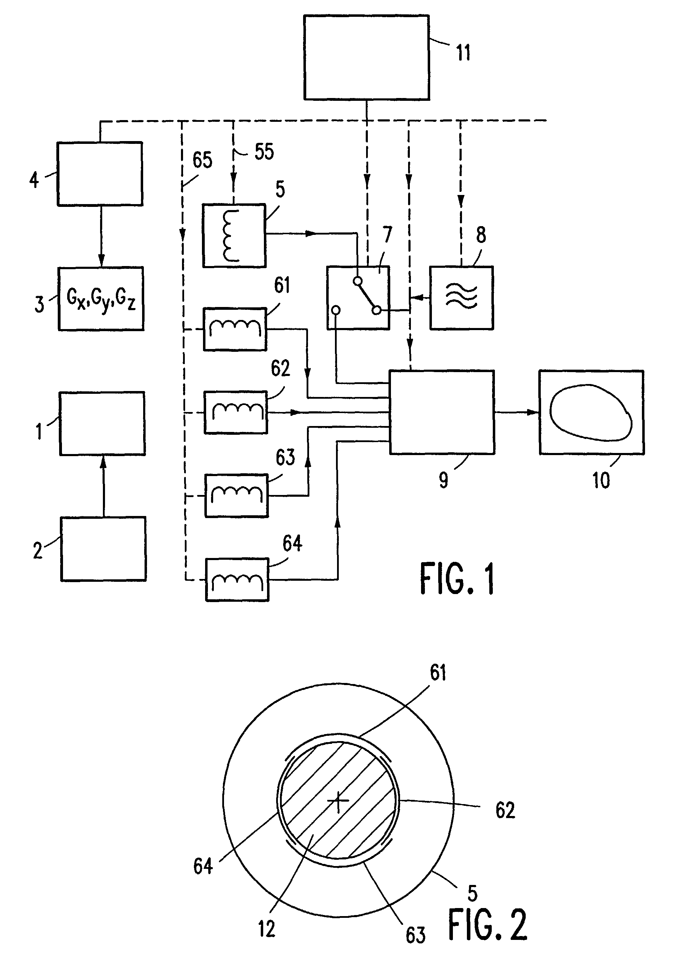

In dem in Fig. 1 schematisch dargestellten Blockschaltbild ist mit 1 ein vorzugsweise supraleitender Magnet bezeichnet, der in einem Untersuchungsbereich, in dem sich ein Patient befinden kann, ein stationäres homogenes Magnetfeld erzeugt. Der dafür erforderliche Strom wird von einer Einheit 2 geliefert. Mit 3 ist eine Gradientenspulenanordnung bezeichnet, mit der ein magnetisches Gradientenfeld erzeugt werden kann, das in Richtung des stationären Magnetfeldes verläuft und dessen Gradient entweder in der gleichen Richtung oder in zwei dazu und zueinander senkrechten Richtungen verläuft. Die Ströme hierfür werden von einer Treiberschaltung 4 geliefert, wobei der zeitliche Verlauf der Ströme von einer Steuereinheit 11 gesteuert wird, die mittels eines geeignet programmierten Prozessors realisiert werden kann.

Außerdem ist ein Hochfrequenzgenerator 8 vorgesehen, der impulsweise Schwingungen mit der Larmorfrequenz des Spinsystems erzeugen kann. Eine Sende/Empfangs-Umschalteinheit 7 verbindet eine Körper-Spulenanordnung (body-coil) 5 wahlweise mit einer Empfängeranordnung 9 oder mit dem Hochfrequenzgenerator 8. Die üblicherweise zylinderförmige Körper-Spulenanordnung umschließt bei einer MR-Untersuchung den Körper des Patienten auf einer bestimmten Länge und erzeugt in diesem ein im wesentlichen homogenes Hochfrequenzmagnetfeld. Darüberhinaus ist eine aus vier Oberflächenspulen 61...64 bestehende Oberflächen-Spulenanordnung vorgesehen. Vorzugsweise umfaßt sie mehr als vier Oberflächenspulen, z.B. sechs oder zwölf, jedoch sind auch weniger möglich.

Fig. 2 zeigt die räumliche Lage der Körper-Spulenanordnung 5, bei der es sich um eine Spule vom bird-cage-Typ handeln kann, sowie die vier Oberflächenspulen 61...64. Die vier Oberflächenspulen 61...64 können auf einem nicht näher dargestellten flexiblen Träger angeordnet sein, der auf einen Patienten 12 herumgewickelt wird. Die Spulen sind dabei so auf dem Träger angeordnet, daß sie sich in einem definierten Bereich überlappen, so daß sich eine gute Entkopplung zwischen diesen Oberflächenspulen ergibt. Die durch diese vier Spulen gebildete Oberflächenspulen-Anordnung ist zwar empfindlicher als die Körper-Spulenanordnung 5, jedoch ist diese Empfindlichkeit - bezogen auf den Untersuchungsbereich, in dem sich der Patient befindet - inhomogen.

Die Einheiten 5...9 und 61...64 werden von der Steuereinheit 11 gesteuert. Für die Oberflächenspulen 61...64 ist dabei eine gemeinsame Steuerleitung 65 vorgesehen. Wenn das Signal auf der Steuerleitung 65 "high" ist, sind die Oberflächenspulen aktiv; andernfalls sind sie inaktiv. Die Umschaltung vom aktiven in den inaktiven Zustand bzw. umgekehrt kann beispielsweise mit Hilfe von PIN-Dioden erfolgen, wie in der US-PS 5,216,367 dargestellt. Auch die Körper-Spulenanordnung 5 kann über eine Steuerleitung 55 in einen aktiven und in einen inaktiven Zustand gebracht werden. Im Sendebetrieb befindet sich die Sende-Empfangs-Umschalteinheit 7 in der in der Zeichnung dargestellten Stellung, so daß die vom Hochfrequenzgenerator 6 erzeugten Schwingungen der Körperspule 9 zugeführt werden, die einen Hochfrequenzimpuls erzeugt, durch den die Kernmagnetisierung im Untersuchungsbereich angeregt wird. Während des Sendebetriebs sind die Oberflächenspulen 61...64 unwirksam.

Wenn die Sende/Empfangsumschalteinheit 7 von der Steuereinheit 11 in die andere Schalterstellung umgeschaltet wird, können mit der Körper-Spulenanordnung 5 die im Untersuchungsbereich entstehenden MR-Signale empfangen werden - falls sie über die Steuerleitung 55 aktiviert ist.

Anstelle einer als Sende- und als Empfangsspule wirksamen Körper-Spulenanordnung können für den Sendebetrieb und für den Empfangsbetrieb gesonderte Spulen vorgesehen sein. Die für den Empfangsbetrieb vorgesehene Körper-Spulenanordnung sollte dabei eine räumlich zumindest näherungsweise konstante Empfindlichkeit haben.

Die Empfängeranordnung 9 enthält für jede Spule 5, 61...64 je einen Kanal, in dem das von der jeweiligen Spule empfangene MR-Signal verstärkt in einen niedrigeren Frequenzbereich transponiert und digitalisiert wird und in dem aus den digitalisierten MR-Signalen jeweils ein MR-Bild rekonstruiert werden kann. Die in der Empfängeranordnung 9 erzeugten MR-Bilder sind auf einem Monitor 11 darstellbar. Von den Spulenanordnungen 5 einerseits und 61...64 andererseits ist jeweils nur eine wirksam. Wenn die MR-Signale von der Körper-Spulenanordnung 5 empfangen werden sollen, sind die Oberflächenspulen 61...64 durch die Steuereinheit 11 inaktiv gemacht. Wenn dagegen mit den Oberflächenspulen 61...64 empfangen werden soll, wird die Körper-Spulenanordnung 5 inaktiv gemacht. Dadurch treten die beiden Spulenanordnungen miteinander nicht in Wechselwirkung.

Es sei angenommen, daß mit einem geeigneten, räumlich hoch auflösenden MR-Verfahren eine MR-Untersuchung vorgenommen worden ist, in deren Verlauf die vier Oberflächenspulen 61...64 (gleichzeitig) genügend MR-Signale aufgenommen haben, um daraus je ein MR-Bild zu rekonstruieren. Da die vier Oberflächenspulen eine örtlich inhomogene Empfindlichkeit aufweisen, schlägt sich das in jedem MR-Bild der Oberflächenspulen 61...64 aber auch in einem daraus durch ein bloße Überlagerung erzeugten MR-Bild nieder; ein homogenes Objekt würde dadurch beispielsweise mit einer inhomogenen Helligkeitsverteilung wiedergegeben.

Daher ist zur Korrektur eine Kalibrationsmessung erforderlich, mit der die Ortsabhängigkeit der Empfindlichkeit der Oberflächenspulen ermittelt werden soll. Bei dieser Kalibrationsmessung sollen sowohl die Körper-Spulenanordnung 5 als auch die Oberflächenspulen 61...64 je ein MR-Bild messen. Diese MR-Bilder können eine geringe räumliche Auflösung haben, da sich die Empfindlichkeit der Oberflächenspulen als Funktion des Ortes nur relativ langsam ändert. Sie müssen aber das gleiche Kontrastverhalten haben, und sie sollen möglichst gleichzeitig aufgenommen werden, damit die Kalibrierung nicht durch Bewegungen im Untersuchungsbereich (der der gleiche ist wie bei dem vorangegangenen MR-Untersuchungsverfahren) verfälscht wird.

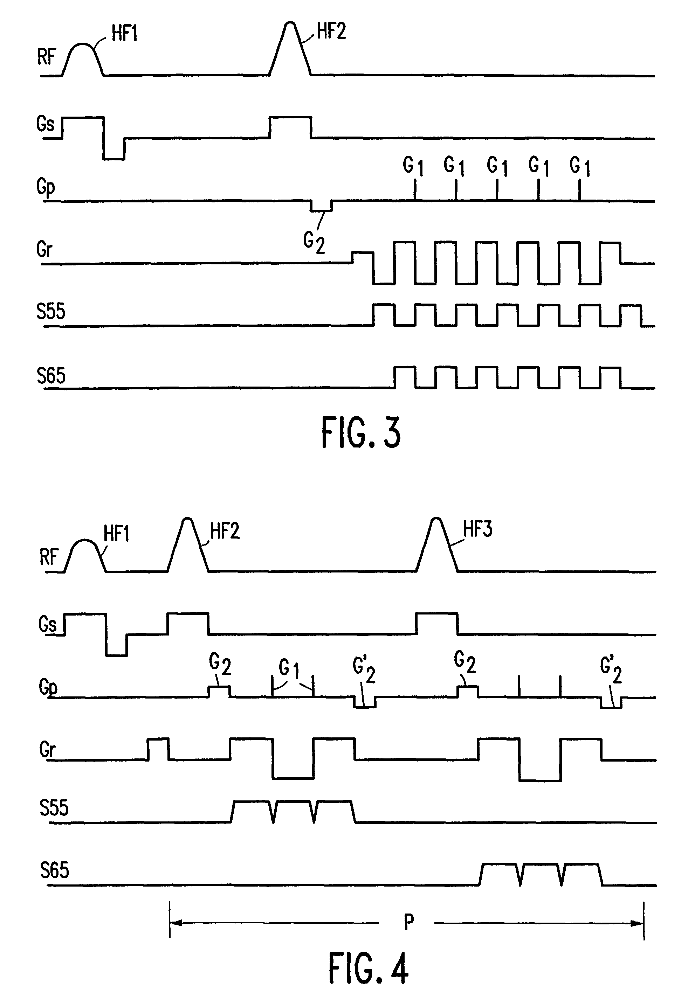

In Fig. 3 ist eine dafür geeignete Kalibrationsmessung dargestellt. Bei dieser Messung wirken auf den Untersuchungsbereich zunächst ein 90°-Hochfrequenzimpuls HF1 und anschließend ein 180° Hochfrequenzimpuls HF2 (erste Zeile) ein. Diese Impulse werden von einem Schichtselektionsgradienten Gₛ begleitet (zweite Zeile), so daß die Hochfrequenz impulse die Kernmagnetisierung in einer bestimmten Schicht beeinflussen, und zwar der gleichen Schicht, die bei der vorangegangenen (oder nachfolgenden) räumlich noch aufgelösten MR-Untersuchung erfaßt wurde bzw. wird. Danach werden die Körperspule 5 einerseits und die Oberflächen-Spulenanordnung 61...64 andererseits zyklisch (bzw., da es sich nur um zwei Empfangs-Spulenanordnungen handelt) alternierend aktiviert und inaktiviert, wie sich aus den Zeilen 5 und 6 der Fig. 3 ergibt, die die Steuersignale S₅₅ und S₆₅ auf den Leitungen 55 und 65 darstellen. Gleichzeitig mit der Umschaltung der Spulen wird die Polarität eines Lesegradienten Gᵣ geändert, so daß sich eine Rephasierung der Kernmagnetisierung ergibt und die jeweils aktive Spulenanordnung ein MR-Signal aufnimmt (vierte Zeile).

Nach jedem Zyklus, d.h. nachdem jede Spulenanordnung einmal empfangen hat, wird im Nulldurchgang des Lesegradienten ein kurzer Impuls des Phasenkodierungsgradienten Gₚ (dritte Zeile) erzeugt, ein sogenannter "blip", wodurch sich die Phasenkodierung der danach erzeugten MR-Signale ändert. Nach n solcher Zyklen ist die Kalibrationsmessung beendet. Die zeitlich Lage der Signale kann dabei so gewählt sein, daß nach der Hälfte (n/2) der Zyklen der zeitliche Abstand zum 180°-Hochfrequenzimpuls HF2 so groß ist, wie dessen Abstand vom ersten Hochfrequenzimpuls HF1. In diesem Fall sollte vor dem ersten Zyklus ein Phasenkodierungsgradient G₂ geschaltet werden, dessen zeitliches Integral halb so groß ist wie das zeitliche Integral aller n blips G₁.

Mit den auf diese Weise gewonnenen MR-Signalen bzw. mit den daraus abgeleiteten MR-Bildern mit geringer räumlicher Auflösung kann das zuvor (oder nachfolgend) nur von den Oberflächenspulen 61...64 aufgenommene MR-Bild, das eine hohe räumliche Auflösung aufweist, korrigiert werden. Wie dies im einzelnen geschehen kann, ist in der deutschen Patentanmeldung P 44 27 429.7 (PHD 94-098) beschrieben, worauf ausdrücklich Bezug genommen wird.

Der Vorteil einer auf diese Weise vorgenommenen Kalibration besteht darin, daß die MR-Signale, die demselben Pfad im sogenannten K-Raum zugeordnet sind, quasi gleichzeitig gemessen werden. Außerdem erfaßt jede der beiden Spulenanordnungen die MR-Signale jeweils bei der gleichen Polarität des Lesegradienten (die Körper-Spulenanordnung 5 bei negativer Polarität und die Oberflächen-Spulenanordnung 61...64 bei positiver Polarität. Dadurch werden die typischen N/2 Bildartefakte vermieden, die bei Sequenzen mit alternierender Polarität des Gradienten auftreten können.

Das beschriebene Verfahren kann in verschiedener Hinsicht abgewandelt werden. Es ist beispielsweise möglich, den refokussierenden 180°-Hochfrequenzimpuls HF2 wegzulassen, so daß die in den Zeilen 3 bis 6 der Fig. 3 dargestellten Umschaltzyklen im Anschluß an den ersten Hochfrequenzimpuls HF1 erfolgen können. Es ist auch nicht erforderlich, daß der erste Impuls ein 90°-Hochfrequenzimpuls ist, sondern es kann auch ein Hochfrequenzimpuls verwendet werden, der die Kernmagnetisierung um weniger als 90° aus ihrer Ruhelage auslenkt. Falls die mit den n MR-Signalen in Richtung des Phasenkodierungsgradienten erzielbare räumliche Auflösung noch nicht ausreicht, kann die in Fig. 3 dargestellte Sequenz so wiederholt werden, daß sie sich lediglich durch die Größe oder das Vorzeichen des Phasenkodierungsgradienten G₂ (dritte Zeile) unterscheidet.

Wenn die vier Oberflächenspulen 61...64 nicht voneinander entkoppelt wären, sollten sie zwecks Vermeidung von Bildartefakten nicht gleichzeitig MR-Signale empfangen. Die Spulen 5 und 61...64 müßten dann zyklisch eingeschaltet werden, wobei ein Zyklus den Empfang je eines MR-Signals durch diese fünf Spulen umfassen würde. Die blips G₁ dürften dann erst jeweils am Ende eines dieser vergrößerten Zyklen auftreten.

Für den Fall, daß die eigentliche MR-Untersuchung mit einer Sequenz des gleichen Typs durchgeführt werden kann, mit der die Kalibrationsmessung durchgeführt wird, können beide auch in einer gemeinsamen Datenakquisition erfolgen. Da für die Kalibrationsbilder eine wesentlich geringere räumliche Auflösung erforderlich ist als für die eigentliche MR-Untersuchung, müßte dem Empfang eines MR-Signals durch die Körper-Spulenanordnung 5 der Empfang von mehreren (z.B. acht oder sechzehn) MR-Signalen durch die Oberflächenspulen 61...64 gegenüberstehen. Das von der Körper-Spulenanordnung 5 aufgenommene MR-Signal und ein mit derselben Phasenkodierung von den Spulen 61...64 aufgenommenes MR-Signal müßten dann zur Kalibration herangezogen werden.

Die in Fig. 3 für eine Schicht dargestellte Sequenz kann für benachbarte Schichten auf einfache Weise wiederholt werden, weil die Kernmagnetisierung in jeder Schicht quasi nur einmal angeregt wird.

Das in Fig. 3 dargestellte Verfahren ist ein 2DFT- bzw 3DFT-Verfahren, bei dem von Zyklus zu Zyklus die Phasenkodierung mittels jeweils eines blips geändert wird. Es ist aber stattdessen auch die Anwendung einer Projektions-Rekonstruktionsmethode möglich, bei der - ohne Phasenkodierung - von Zyklus zu Zyklus die Richtung des Lesegradienten geändert wird. Das Verfahren kann darüberhinaus auch bei MR Sequenzen angewandt werden, die in anderer Weise die MR-Daten akquirieren.

Die Erfindung ist nicht auf Verfahren beschränkt, bei denen das MR-Bild einer ersten Spule mit Hilfe von MR-Daten einer weiteren, damit gekoppelten MR-Spule kalibriert werden soll; sie ist immer dann anwendbar, wenn es darum geht, die Kernmagnetisierungsverteilung in einem Untersuchungsbereich mit mehreren Spulen zu erfassen, die so stark miteinander gekoppelt sind, daß die gleichzeitige Erfassung zu Bildartefakten führen würde. Ein weiteres Beispiel dafür ist die interventionelle MR, mit der beispielsweise der Vorschub eines mit einer aktiven Empfangsspule ausgerüsteten Katheters (oder eines anderen chirurgischen Gerätes) im menschlichen Körper beobachtet werden kann. Dabei kann es einerseits erforderlich sein, jeweils einen ganzen Bilddatensatz zu akquirieren, andererseits kann aber auch die Messung einzelner Projektionen des Objektes für die dreidimensionale Navigation des Katheters (oder des chirurgischen Gerätes) erforderlich sein.

In Fig. 4 ist ein weiteres Ausführungsbeispiel dargestellt, das auf einer sogenannten GRASE-Sequenz beruht, bei der die Rephasierung einerseits durch 180°-Hochfrequenzimpulse und andererseits durch einen alternierenden Lesegradienten erfolgt. Demgemäß folgt auf den 90°-Hochfrequenzimpuls HF1 (1. Zeile) ein erster 180°-Hochfrequenzimpuls HF2. Danach wird der Lesegradient Gᵣ (4. Zeile) zunächst mit positiver, dann mit negativer und dann wieder mit positiver Polarität eingeschaltet, so daß drei MR-Signale entstehen, die infolge der blips G₁ eine unterschiedliche Phasenkodierung aufweisen. Vor dem Lesegradienten Gᵣ wird der Phasenkodierungsgradient Gₚ eingeschaltet (G₂), und nach dem Lesegradienten wird er ausgeschaltet (G₂'), wobei das zeitliche Integral über G₂, G₂' und die blips G₁ Null sein muß. Die drei MR-Signale im Anschluß an den Hochfrequenzimpuls HF2 werden nur von der Spule 5 empfangen, weil sie durch das Signal S₅₅ aktiviert ist, während das Signal S₆₅ in dieser Phase die Spulen 61...64 inaktiviert. Diese MR-Echosignale werden auch als unter dem ersten "Hahn-Echo" aufgenommen bezeichnet.

Anschließend wird ein Hochfrequenzimpuls HF3 erzeugt, wobei sich im Anschluß daran der gleiche zeitliche Verlauf des Phasenkodierungsgradienten Gₚ und des Lesegradienten Gᵣ ergibt wie nach HF2. Jedoch werden unter diesem Hahn-Echo die drei MR-Gradienten-Echosignale von den Spulen 61...64 aufgenommen, weil diese durch das Signal S₆₅ aktiviert sind, während die Spule 5 inaktiv ist.

Der in der Zeichnung mit P bezeichnete Abschnitt der Sequenz wird danach mehrfach wiederholt. wobei von Wiederholung zu Wiederholung lediglich G₂ und G₂' variiert werden, so daß die resultierenden MR-Gradienten-Echosignale eine unterschiedliche Phasenkodierung aufweisen.

Eine weitere Möglichkeit besteht darin, daß unter jedem Hahn-Echo für alle Empfangs-Spulenanordnungen nur ein Phasenkodierschritt in den Gradienten-Echos gemessen wird. Der blip G₁ wird somit identisch Null und G₂ = -G₂' gesetzt. Dieser Ansatz ist allerdings nur dann sinnvoll, wenn die Anzahl der Empfangs-Spulenanordnungen ungerade ist.

Die in Fig. 4 dargestellte Sequenz kann insofern modifiziert werden, als im Intervall zwischen zwei refokussierenden Hochfrequenzimpulsen HF2 und HF3 mehr Echosignale - aber auch weniger - empfangen werden können. Wenn jeweils nur ein MR-Echosignal erzeugt wird, ergibt sich eine RARE-Sequenz, bei nach jedem 180°-Hochfrequenzimpuls eine andere Spule empfangsbereit ist.

## Patentansprüche

1. Verfahren der magnetischen Resonanz (MR), bei dem mehrere miteinander induktiv gekoppelte Empfangs-Spulenanordnungen vorgesehen sind,
gekennzeichnet durch folgende Verfahrensschritte:
a) Anregen der Kernmagnetisierung in einem Untersuchungsbereich, der einem homogenen stationären Magnetfeld ausgesetzt ist, mit wenigstens einem Hochfrequenzimpuls
b) mehrfache Rephasierung der angeregten Kernmagnetisierung zur Erzeugung mehrerer MR-Echosignale, deren Zahl mindestens gleich der Zahl m der Empfangs-Spulenanordnungen ist,
c) Umschalten der Empfangs-Spulenanordnungen derart, daß jede Empfangs-Spulenanordnung im Anschluß an diese Anregung mindestens ein MR-Echosignal empfängt, während alle übrigen Empfangsspulenanordnungen jeweils inaktiv sind.

2. MR-Verfahren nach Anspruch 1,
dadurch gekennzeichnet, daß m·n MR-Echosignale im Anschluß an eine Anregung der Kernmagnetisierung erzeugt werden, wobei m die Zahl der Empfangs-Spulenanordnungen (5; 61...64) ist und n eine ganze Zahl größer als Null, und daß die Empfangs-Spulenanordnungen zyklisch umgeschaltet werden, so daß jede Empfangs-Spulenanordnung insgesamt n MR-Echosignale empfängt

3. MR-Verfahren nach Anspruch 2,
dadurch gekennzeichnet, daß die Empfangs-Spulenanordnungen im Anschluß an eine einzige Anregung in n Empfangs-Zyklen aktiviert werden, wobei in jedem Empfangs-Zyklus alle Empfangs-Spulenanordnungen je ein in gleicher Weise von den Gradientenfeldern beeinflußtes MR-Echosignal empfangen wie die anderen Empfangs-Spulenanordnungen, und daß von Empfangs-Zyklus zu Empfangs-Zyklus die frequenz- oder phasenbestimmenden Gradienten variiert werden.

4. MR-Verfahren nach Anspruch 2,
dadurch gekennzeichnet, daß die Empfangs-Spulenanordnungen im Anschluß an eine Anregung in einem einzigen Empfangs-Zyklus aktiviert werden, in dem jede Empfangs-Spulenanordnung nacheinander n MR-Signale erfaßt, wobei aufeinanderfolgenden MR-Echosignale in unterschiedlicher Weise von einem Phasenkodiergradienten beeinflußt werden.

5. MR-Verfahren nach Anspruch 3,
dadurch gekennzeichnet, daß die Rephasierung der Kernmagnetisierung mittels eines Lesegradienten mit alternierender Polarität erfolgt, wobei die Empfangs-Zyklen so gestaltet sind, daß jede Empfangs-Spulenanordnung nur MR-Echosignale empfängt, die bei derselben Polarität des Lesegradienten auftreten, und daß zwischen aufeinanderfolgenden Empfangs-Zyklen ein Phasenkodiergradient geändert wird.

6. MR-Verfahren nach Anspruch 5 mit einer Oberflächen-Spulenanordnung mit örtlich inhomogener Empfindlichkeit und einer Spulenanordnung mit örtlich homogener Empfindlichkeit,
dadurch gekennzeichnet, daß die beiden Spulenanordnungen alternierend eingeschaltet werden und daß aus den MR-Echosignalen beider Spulenanordnungen Kalibrationsdaten zur Korrektur der örtlich inhomogener Empfindlichkeit der Oberflächen-Spulenanordnung abgeleitet werden.

7. MR-Verfahren nach Anspruch 4,
dadurch gekennzeichnet, daß nach dem Empfang von n MR-Echosignalen durch eine Empfangs-Spulenanordnung und vor dem Aktivieren der nächsten Empfangs-Spulenanordnung ein 180°- Hochfrequenzimpuls erzeugt wird.

8. MR-Gerät zur Durchführung des Verfahrens nach Anspruch 1 mit
einem Magneten (1,2) zur Erzeugung eines homogenen stationären Magnetfeldes,
einer an einen Sender (8) anschließbaren Spulenanordnung (5) zur Erzeugung von Hochfrequenzimpulsen (HF1, HF2 ...) zwecks Anregung der Kernmagnetisierung,
Gradientenspulenanordnungen (3) zur Erzeugung magnetischer Gradlentenfelder,
mindestens zwei induktiv miteinander gekoppelten Empfangs-Spulenanordnungen (5; 61...64),
Umschalt-Mitteln (55, 65) zum Umschalten der Empfangs-Spulenanordnungen derart, daß jeweils nur eine Empfangs-Spulenanordnung empfangen kann, und
einer Steuereinheit (11) zur Steuerung der Komponenten des MR-Gerätes derart, daß sich folgender Ablauf ergibt:
a) Anregen der Kernmagnetisierung in einem Untersuchungsbereich, der einem homogenen stationären Magnetfeld ausgesetzt ist, mit wenigstens einem Hochfrequenzimpuls
b) mehrfache Rephasierung der angeregten Kernmagnetisierung zur Erzeugung mehrerer MR-Echosignale, deren Zahl mindestens gleich der Zahl m der Empfangs-Spulenanordnungen ist,
c) Umschalten der Empfangs-Spulenanordnungen derart, daß jede Empfangs-Spulenanordnung im Anschluß an diese Anregung mindestens ein MR-Echosignal empfängt, während alle übrigen Empfangsspulenanordnungen jeweils inaktiv sind.

## Claims

1. A magnetic resonance (MR) method, utilizing a plurality of inductively coupled receiving coil systems,
characterized in that it includes the following steps:
a) excitation of the nuclear magnetization in an examination zone, exposed to a uniform, steady magnetic field, by means of at least one RF pulse,
b) multiple rephasing of the excited nuclear magnetization in order to generate a plurality of MR echo signals whose number at least equals the number m of receiving coil systems,
c) switching over the receiving coil systems in such a manner that subsequent to said excitation each receiving coil system receives at least one MR echo signal while at the same time all respective other coil systems are inactive.

2. An MR method as claimed in Claim 1,
characterized in that m.n MR echo signals are generated subsequent to an excitation of the nuclear magnetization, m being the number of receiving coil systems (5; 61 ... 64) and n an integer larger than zero, the receiving coil systems being cyclically switched over so that each receiving coil system receives a total of n MR echo signals.

3. An MR method as claimed in Claim 2,
characterized in that, subsequent to a single excitation, the receiving coil systems are activated in n receiving cycles, in each receiving cycle all receiving coil systems receiving a respective MR echo signal which has been influenced by the gradient fields in the same way as those received by the other receiving coil systems, the gradients determining the frequency or the phase being varied from one receiving cycle to another.

4. An MR method as claimed in Claim 2,
characterized in that, subsequent to an excitation the receiving coil systems are activated in a single receiving cycle in which each receiving coil system successively detects n MR signals, successive MR echo signals being influenced differently by a phase encoding gradient.

5. An MR method as claimed in Claim 3,
characterized in that the rephasing of the nuclear magnetization is performed by means of a read gradient of alternating polarity, the receiving cycles being configured in such a manner that each receiving coil system receives only MR echo signals which occur at the same polarity of the read gradient, and that a phase encoding gradient is varied between successive receiving cycles.

6. An MR method as claimed in Claim 5, utilizing a surface coil system having a locally inhomogeneous sensitivity and a coil system having a locally homogeneous sensitivity, characterized in that the two coil systems are alternately switched on and that calibration data for correcting the locally inhomogeneous sensitivity of the surface coil system is derived from the MR echo signals of both coil systems.

7. An MR method as claimed in Claim 4,
characterized in that a 180° RF pulse is generated after the reception of n MR echo signals by a receiving coil system and before the activation of the next receiving coil system.

8. An MR apparatus for carrying out the method claimed in Claim 1, including
a magnet (1, 2) for generating a uniform, steady magnetic field,
a coil system (5) which can be connected to a transmitter (8) in order to generate RF pulses (HF1, HF2 ...) for the excitation of the nuclear magnetization,
gradient coil systems (3) for generating magnetic gradient fields,
at least two receiving coil systems (5; 61 ... 64) which are inductively coupled to one another,
switching means (55, 65) for switching over the receiving coil systems in such a manner that each time only one receiving coil system can operate in the receiving mode,
a control unit (11) for controlling the components of the MR apparatus in such a manner that the following sequence is obtained:
a) excitation of the nuclear magnetization in an examination zone, exposed to a uniform, steady magnetic field, by means of at least one RF pulse,
b) multiple rephasing of the excited nuclear magnetization in order to generate a plurality of MR echo signals whose number at least equals the number m of receiving coil systems,
c) switching over the receiving coil systems in such a manner that subsequent to said excitation each receiving coil system receives at least one MR echo signal while at the same time all respective other receiving coil systems are inactive.

## Revendications

1. Procédé de résonance magnétique (MR) qui prévoit plusieurs agencements de bobines de réception à couplage réciproque inductif,
caractérisé par les étapes de procédé suivantes :
a) excitation de la magnétisation nucléaire dans une zone d'examen qui est exposée à un champ magnétique stationnaire homogène avec au moins une impulsion à haute fréquence,
b) un rephasage multiple de la magnétisation nucléaire excitée en vue de la production de plusieurs signaux d'écho RM dont le nombre est au moins égal au nombre m des agencements de bobines de réception,
c) la commutation des agencements de bobines de réception de telle sorte que chaque agencement de bobines de réception reçoive au moins un signal d'écho RM à la suite de cette excitation tandis que tous les autres agencements de bobines de réception sont respectivement inactifs.

2. Procédé RM selon la revendication 1,
caractérisé en ce que m·n signaux d'écho RM sont produits à la suite d'une excitation de la magnétisation nucléaire, m étant le nombre d'agencements de bobines de réception (5; 61 ... 64) et n un nombre entier supérieur à zéro, et que les agencements de bobines de réception sont commutés cycliquement de telle sorte que chaque agencement de bobines de réception reçoive au total n signaux d'écho RM.

3. Procédé RM selon la revendication 2,
caractérisé en ce que les agencements de bobines de réception sont activés à la suite d'une excitation unique en n cycles de réception, tous les agencements de bobines de réception recevant respectivement un signal d'écho RM influencé par les champs à gradient de la même manière que les autres agencements de bobines de réception dans chaque cycle de réception et que les gradients déterminés par la fréquence et la phase variant d'un cycle de réception à l'autre.

4. Procédé RM selon la revendication 2,
caractérisé en ce que les agencements de bobines de réception sont activés à la suite d'une excitation dans un cycle de réception unique dans lequel chaque agencement de bobines de réception enregistre successivement n· signaux RM, les signaux d'écho RM successifs étant influencés de manière différente par un gradient de codage de phase.

5. Procédé RM selon la revendication 3,
caractérisé en ce que le rephasage de la magnétisation nucléaire intervient à l'aide d'un gradient de lecture de polarité alternée, les cycles de réception étant conçus de telle sorte que chaque agencement de bobines de réception ne reçoive que des signaux d'écho RM qui se forment pour la même polarité du gradient de lecture et qu'entre les cycles de réception successifs, un gradient de codage de phase est modifié.

6. Procédé RM selon la revendication 5 avec un agencement de bobines de surface présentant une sensibilité non homogène locale et un agencement de bobines avec une sensibilité homogène locale,
caractérisé en ce que les deux agencements de bobines sont commutés en alternance et qu'à partir des signaux d'écho RM des deux agencements de bobines, des données de calibrage peuvent être dérivées en vue de la correction de la sensibilité non homogène localement de l'agencement de bobines de surface.

7. Procédé RM selon la revendication 4,
caractérisé en ce qu'après la réception de n signaux d'écho RM par un agencement de bobines de réception et avant l'activation de l'agencement de bobines de réception suivant, une impulsion de haute fréquence de 180° est produite.

8. Appareil RM de mise en oeuvre du procédé selon la revendication 1 avec
un aimant (1, 2) en vue de la production d'un champ magnétique stationnaire homogène,
un agencement de bobines (5) susceptible d'être raccordé à un émetteur (8) en vue de la production d'impulsions à haute fréquence (HF1, HF2, ...) en vue de l'excitation de la magnétisation nucléaire,
des agencements de bobines à gradient (3) en vue de la production de champs à gradient magnétiques,
au moins deux agencements de bobines de réception à couplage inductif (5; 61 ... 64),
des moyens de commutation (55, 65) en vue de la commutation des agencements de bobines de réception de telle sorte que seul un agencement de bobines de réception puisse respectivement recevoir, et
une unité de commande (11) en vue de la commande des composants de l'appareil RM de telle sorte que la procédure suivante se déroule :
a) excitation de la magnétisation nucléaire dans une zone d'examen qui est exposée à un champ magnétique stationnaire homogène avec au moins une impulsion à haute fréquence,
b) rephasage multiple de la magnétisation nucléaire excitée en vue de la production de plusieurs signaux d'écho RM dont le nombre est au moins égal au nombre m des agencements de bobines de réception,
c) la commutation des agencements de bobines de réception de telle sorte que chaque agencement de bobines de réception reçoive à la suite de cette excitation au moins un signal d'écho RM tandis que tous les autres agencements de bobines de réception sont respectivement inactifs.
